# EUROPEAN PATENT APPLICATION

(11) **EP 4 303 918 A1**
(43) Date of publication of application: **10.01.2024**
(21) Application number: 23181471.6
(22) Date of filing: 26.06.2023
(51) Int. Cl.: H01L 23/495, H01L 21/56, H01L 23/31, H01L 23/538

(54) **SEMICONDUCTOR DEVICE WITH LEAD-ON-CHIP INTERCONNECT AND METHOD THEREFOR**

(30) Priority: 06.07.2022 US 202217810882
(71) Applicant: NXP B.V., 5656 AG Eindhoven (NL)
(72) Inventor: Mao, Kuan-Hsiang, 5656AG Eindhoven (NL); Siong, Chin Teck, 5656AG Eindhoven (NL); Hiew, Pey Fang, 5656AG Eindhoven (NL); Chuang, Wen Yuan, 5656AG Eindhoven (NL); Tay, Sharon Huey Lin, 5656AG Eindhoven (NL); Huang, Wen Hung, 5656AG Eindhoven (NL)
(74) Representative: Hardingham, Christopher Mark

(57) **Abstract**

A method of forming a semiconductor device is provided. The method includes placing a semiconductor die and a leadframe on a carrier substrate. The semiconductor die includes a plurality of bond pads and the leadframe includes a plurality of leads. A first lead of the plurality of leads has a proximal end affixed to a first bond pad of the plurality of bond pads and a distal end placed on the carrier substrate. At least a portion of the semiconductor die and the leadframe is encapsulated with an encapsulant. The carrier substrate is separated from a first major side of the encapsulated semiconductor die and leadframe exposing a distal end portion of the first lead. A package substrate is applied on the first major side.

## Description

### Background

### Field

This disclosure relates generally to semiconductor device packaging, and more specifically, to semiconductor devices with lead-on-chip interconnect and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some features and applications, the configuration of the semiconductor device packages may be susceptible to lower reliability, lower performance, and higher product or system costs. Accordingly, significant challenges exist in accommodating these features and applications while minimizing the impact on semiconductor devices' reliability, performance, and costs.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in a simplified bottom-side-up plan view, an example semiconductor device having lead-on-chip interconnect at a stage of manufacture in accordance with an embodiment.
FIG. 2 through FIG. 8 illustrate, in simplified cross-sectional views, the example semiconductor device at stages of manufacture in accordance with an embodiment.
FIG. 9 through FIG. 11 illustrate, in simplified cross-sectional views, example external components affixed on the example semiconductor device in accordance with embodiments.

### Detailed Description

Generally, there is provided, a semiconductor device having lead-on-chip interconnects. The semiconductor device includes a semiconductor die and a leadframe at least partially encapsulated with an encapsulant. A first end of leads of the leadframe are affixed to bond pads of the semiconductor die and a second end of the leads are exposed through a bottom side of the encapsulant. A package substrate is formed on the bottom side to interconnect the semiconductor die with a printed circuit board, for example. The package substrate may be formed as a build-up substrate or may be provided as a pre-formed substrate. By forming the semiconductor device with the lead-on-chip interconnects in this manner, the semiconductor device can operate with higher currents than typical bond wires allow. In an alternative configuration, the first end of the leads may be exposed in a subsequent operation thus allowing greater flexibility with through package interconnection by way of the leadframe leads.

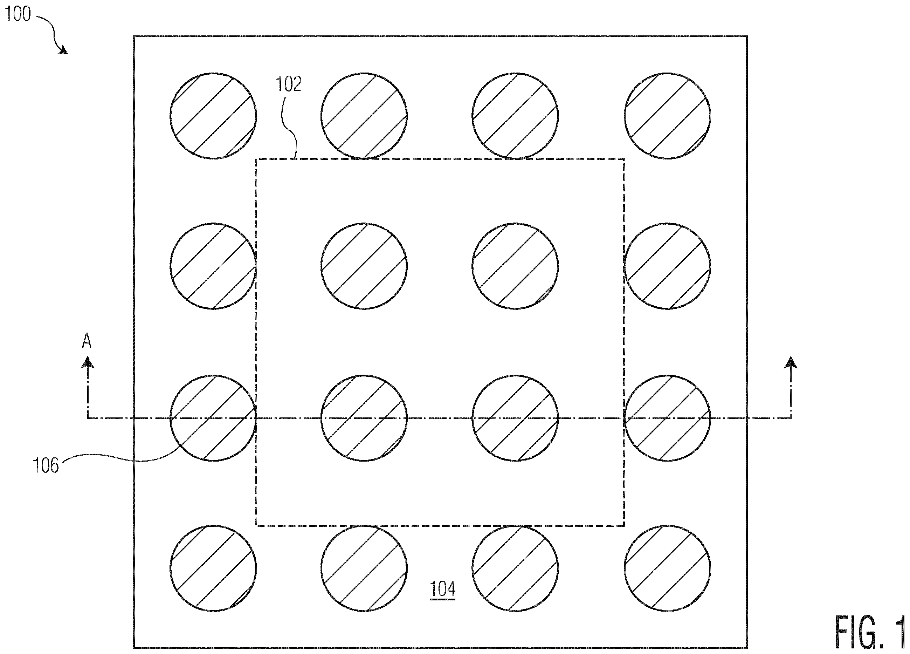

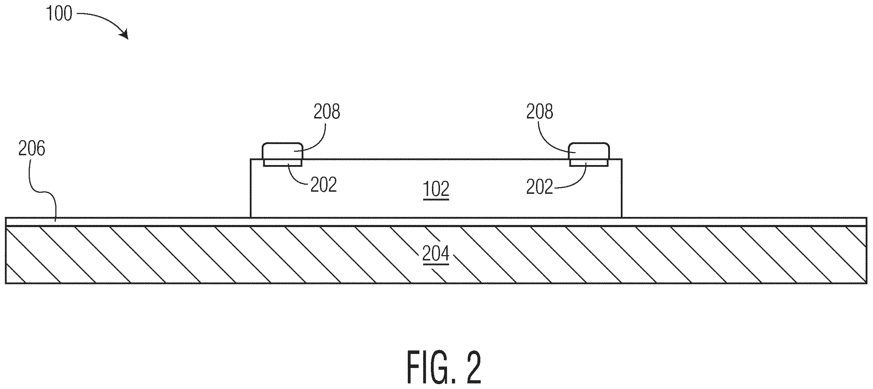

FIG. 1 illustrates, in a simplified bottom-side-up plan view, an example semiconductor device 100 having lead-on-chip interconnect at a stage of manufacture in accordance with an embodiment. In this embodiment, a bottom side of an interconnecting package substrate 104 applied on the semiconductor device 100 is depicted. A plurality of conductive connectors 106 (e.g., solder balls) are affixed to the bottom side of the package substrate 104. An underlying semiconductor die 102 (shown as dashed outline for reference) and leadframe (not shown) are embedded in an encapsulant of the semiconductor device 100. The number and arrangement of the conductive connectors 106 in this embodiment are chosen for illustration purposes. The term "conductive," as used herein, generally refers to electrical conductivity unless otherwise specified. Simplified cross-sectional views of the example semiconductor device 100 taken along line A-A at stages of manufacture are depicted in FIG. 2 through FIG. 8.

FIG. 2 illustrates, in a simplified cross-sectional view, the example semiconductor device 100 taken along line A-A at a stage of manufacture in accordance with an embodiment. At this stage, the semiconductor device 100 includes the semiconductor die 102 placed on a carrier substrate 204. The carrier substrate 204 includes a releasable adhesive 206 applied on a top surface. The carrier substrate 204 is configured and arranged to provide a temporary structure for placement of the semiconductor die 102 (and leadframe) during encapsulation at a subsequent stage of manufacture, for example.

The semiconductor die 102 has an active side (e.g., major side having circuitry) and a backside (e.g., major side opposite of the active side). The semiconductor die 102 includes bond pads 202 formed at the active side. In this embodiment, semiconductor die 102 is oriented with the active side up having the backside temporarily affixed on the carrier substrate 204. The semiconductor die 102 may be formed from any suitable semiconductor material, such as silicon, germanium, gallium arsenide, gallium nitride, and the like. The semiconductor die 102 further includes any digital circuits, analog circuits, RF circuits, power circuits, memory, processor, the like, and combinations thereof formed at the active side. In this embodiment, a conductive bump 208 is applied to each of the bond pads 202. The conductive bump 208 may be formed from suitable conductive materials such as gold, silver, copper, nickel, solder, the like, and alloys thereof.

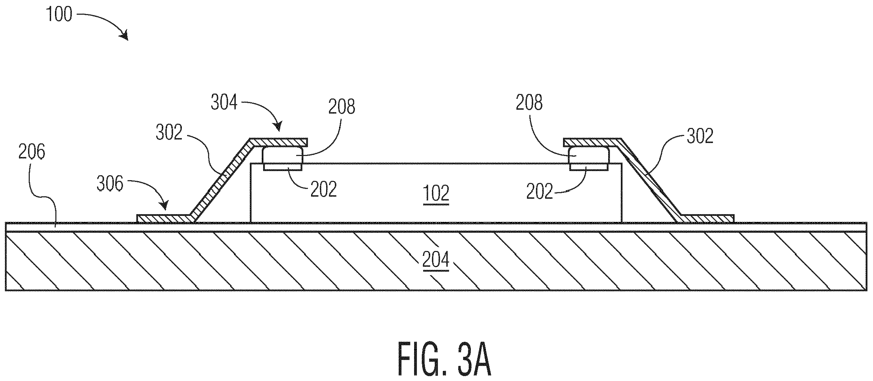

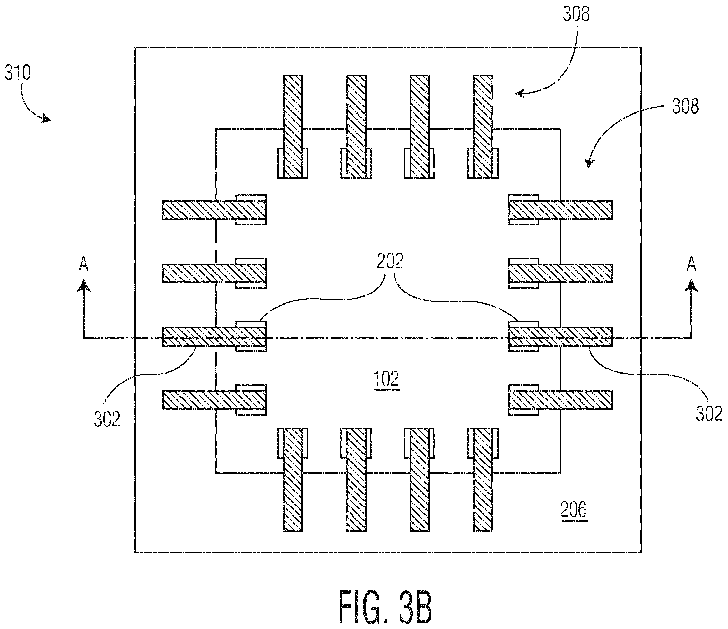

FIG. 3A and FIG. 3B illustrate, in simplified cross-sectional and plan views, the example semiconductor device 100 at a subsequent stage of manufacture in accordance with an embodiment. For example, FIG. 3A depicts a cross-sectional view and FIG. 3B depicts a top-side-up plan view 310 of the semiconductor device 100 with the corresponding section line A-A shown for reference. At this stage, the semiconductor device 100 includes a leadframe 308 placed over a portion of the semiconductor die 102 and on the carrier substrate 204. The leadframe 308 includes a plurality of leads 302 configured for attachment to bond pads 202 of the semiconductor die 102. Each lead 302 of the plurality of leads has a proximal end portion 304 overlapping a bond pad region of the semiconductor die 102 and a distal end portion 306 placed on the carrier substrate 204. The bond pad region generally includes the area of the bond pad 202 plus the area between the bond pad and the outer edge of the semiconductor die 102, for example. The proximal end portion 304 is affixed to a respective bond pad 202 by way of thermocompression bonding, thermosonic bonding, or other suitable process during the stage of placing the leadframe 308 over the semiconductor die 102 and on the carrier substrate 204.

The leads 302 of the leadframe 308 may be formed from any suitable electrically conductive metal material, such as copper, silver, nickel, aluminum, or iron, or alloys thereof, for example. The conductive metal may be bare, partially plated, or plated with another metal or alloy such thereof. In some embodiments, the leads 302 may include being used for thermal conduction as well as electrical conduction. The number and arrangement of leads 302 of the leadframe 308 are chosen for illustration purposes.

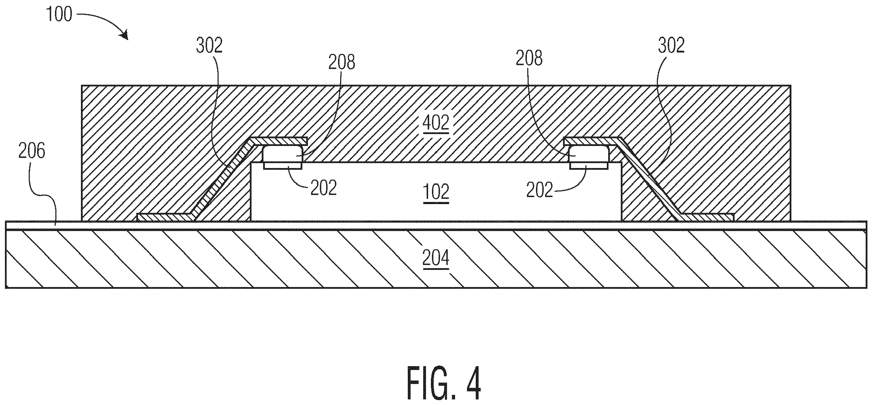

FIG. 4 illustrates, in a simplified cross-sectional view, the example semiconductor device 100 at a subsequent stage of manufacture in accordance with an embodiment. At this stage, the semiconductor device 100 includes the semiconductor die 102 and the leadframe 308 at least partially encapsulated with an encapsulant 402 while temporarily affixed on the carrier substrate 204. In this embodiment, the semiconductor die 102 and the leadframe 308 are over-molded with the encapsulant 402 (e.g., epoxy molding compound) by way of a molding process.

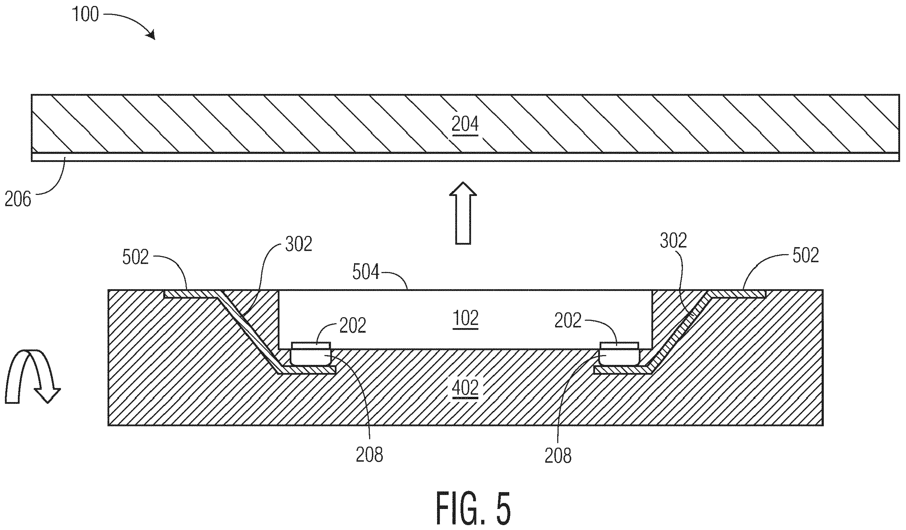

FIG. 5 illustrates, in a simplified cross-sectional view, the example semiconductor device 100 at a subsequent stage of manufacture in accordance with an embodiment. At this stage, the encapsulated semiconductor device 100 is separated from the carrier substrate 204 and reoriented (e.g., flipped). The backside 504 of the semiconductor die 102 and distal end portions 502 of the leads 302 are revealed at a first major side of the encapsulated semiconductor device 100 when the carrier substrate 204 is removed. After the carrier substrate 204 is removed, the encapsulated semiconductor device 100 is oriented in a bottom-side-up configuration for application of a package substrate at a subsequent stage of manufacture, for example.

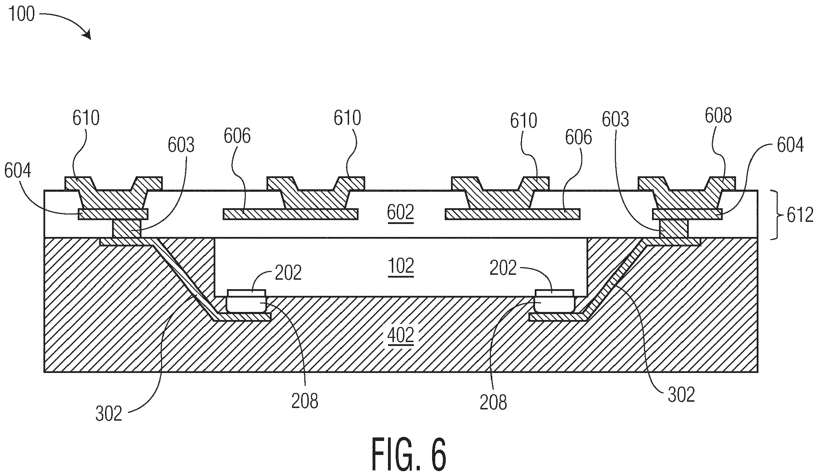

FIG. 6 illustrates, in a simplified bottom-side-up cross-sectional view, the example semiconductor device 100 at a subsequent stage of manufacture in accordance with an embodiment. At this stage, an interconnecting package substrate 612 is applied to a first major side of the encapsulated semiconductor device 100. After the backside of the semiconductor die 102 and the distal end portions of the leads 302 are exposed at the first major side, the package substrate 612 is applied.

The package substrate 612 includes conductive features (e.g., traces 603-606, substrate pads 608-610) surrounded by non-conductive material 602 (e.g., dielectric). In this embodiment, the conductive traces 603-606 and the conductive substrate pads 608-610 are formed from patterned metal (e.g., copper) layers separated by dielectric layers of the package substrate 612. The traces 603-606 and pads 608-610 are formed in the package substrate to interconnect the semiconductor die 102 with a printed circuit board (PCB), for example. The conductive substrate pads 608-610 are exposed at the bottom side of the package substrate 612 and configured for attachment of conductive connectors at a subsequent stage of manufacture. The package substrate 612 may be formed as a build-up substrate directly on the first major side of the encapsulated semiconductor device 100 or may be provided as a pre-formed substrate otherwise applied on the first major side.

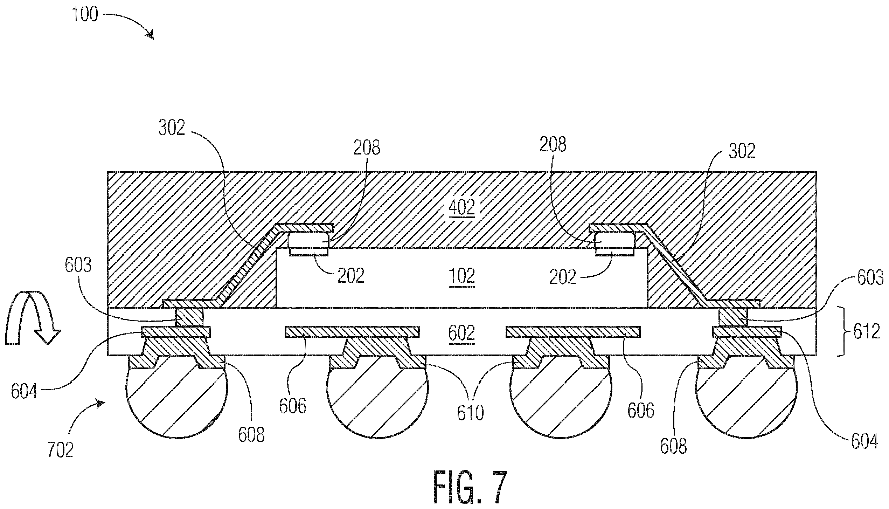

FIG. 7 illustrates, in a simplified cross-sectional view, the example semiconductor device 100 at a subsequent stage of manufacture in accordance with an embodiment. At this stage, after applying the package substrate 612 to the first major side of the encapsulated semiconductor device 100, conductive connectors 702 (e.g., solder balls) are affixed to the substrate pads 608-610 exposed at the bottom side of the package substrate 612 and the semiconductor device 100 is reoriented (e.g., flipped). The conductive connectors 702 are configured and arranged to provide conductive connections between the semiconductor device 100 and a PCB, for example. The conductive connectors 702 may be in the form of any suitable conductive structures such as solder balls, gold studs, copper pillars, and the like, to connect conductive features of the semiconductor device 100 with the PCB. As an alternative to conductive connectors 702, the substrate pads 608-610 may be plated and configured for subsequent connection with the PCB by way of solder paste attachment or other suitable conductive attachment processes (e.g., ACF, ACP).

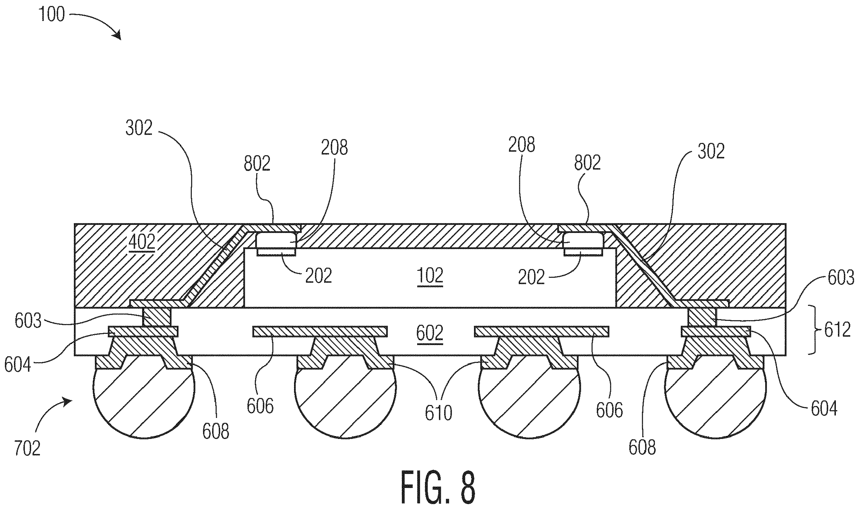

FIG. 8 illustrates, in a simplified cross-sectional view, the example semiconductor device 100 at a subsequent stage of manufacture in accordance with an embodiment. At this stage, proximal end portions 802 of leads 302 are revealed through a second major side of the encapsulated semiconductor device 100. In this embodiment, the encapsulated semiconductor device 100 is subjected to a grind operation at the second major side to expose the proximal end portions 802 of leads 302 through the encapsulant. By having the proximal end portions 802 of leads 302 exposed, through package interconnection may be utilized at a subsequent stage of manufacture. In some embodiments, an alternative molding process may be employed to encapsulate the semiconductor device 100 such that the proximal end portions 802 of leads 302 may be exposed without using a grind operation.

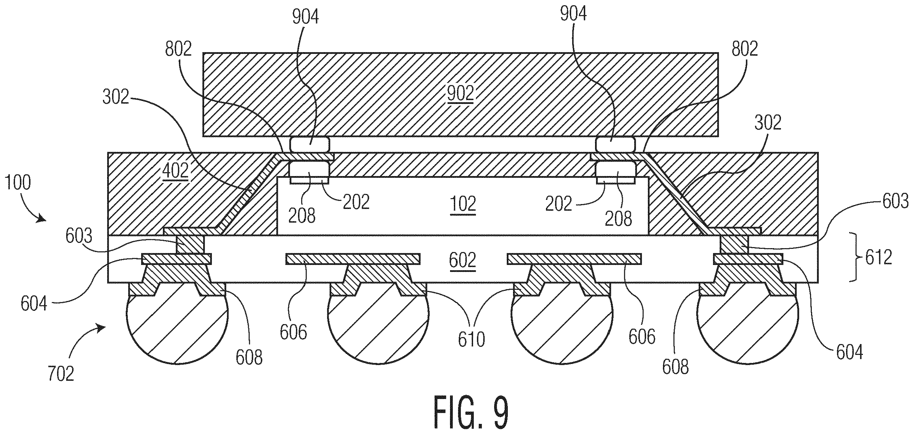

FIG. 9 through FIG. 11 illustrate, in simplified cross-sectional views, example external components affixed on the example semiconductor device 100 in accordance with embodiments.

FIG. 9 illustrates, in a simplified cross-sectional view, the example semiconductor device 100 at a subsequent stage of manufacture in accordance with an embodiment. At this stage, an external component 902 is conductively connected to the exposed proximal end portions 802 of leads 302. In this embodiment, the external component 902 includes connection pads (not shown) which are affixed to the proximal end portions 802 by way of a conductive interface material 904 (e.g., solder, solder paste, conductive adhesive). The external component 902 as depicted in FIG. 9 is chosen for illustration purposes. The external component 902 may be any of a second packaged semiconductor device, an active element (e.g., transistor, diode), a passive element (e.g., resistor, capacitor, inductor), and the like.

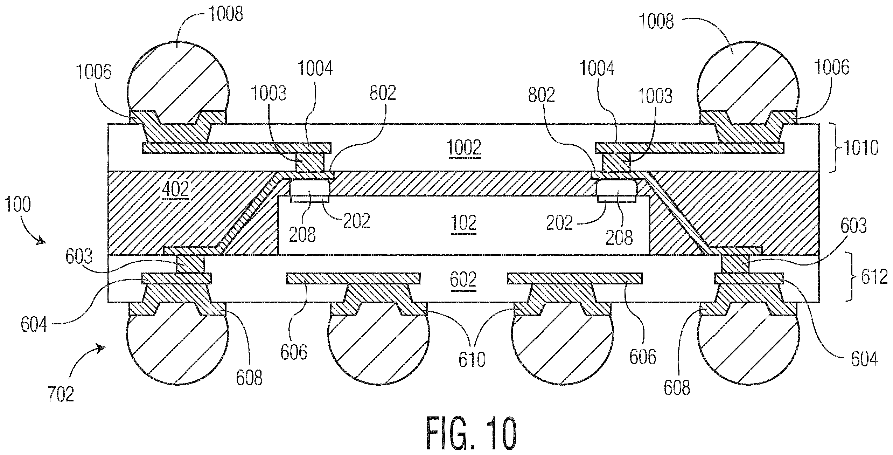

FIG. 10 illustrates, in a simplified cross-sectional view, the example semiconductor device 100 at an alternative stage of manufacture in accordance with an embodiment. At this stage, a second package substrate 1010 is applied to the second major side of the encapsulated semiconductor device 100 and interconnected to the exposed proximal end portions 802 of leads 302. After the proximal end portions 802 of leads 302 are exposed at second first major side as shown in FIG. 8, the second package substrate 1010 may be applied.

The second package substrate 1010 includes conductive features (e.g., traces 1003-1004, substrate pads 1006) surrounded by non-conductive material 1002 (e.g., dielectric). In this embodiment, the conductive traces 1003-1004 and the conductive substrate pads 1006 of the second package substrate 1010 are formed from patterned metal (e.g., copper) layers separated by dielectric layers. The traces 1003-1004 and pads 1006 are formed in the second package substrate 1010 to interconnect the semiconductor die 102 with a second PCB or other external component, for example. The package substrate 1010 may be formed as a build-up substrate directly on the second major side of the encapsulated semiconductor device 100 or may be provided as a pre-formed substrate otherwise applied on the second major side.

Conductive connectors 1008 (e.g., solder balls) are affixed to the exposed substrate pads 1006 of the package substrate 1010. The conductive connectors 1008 are configured and arranged to provide conductive connections between the semiconductor device 100 and a second PCB, for example. The conductive connectors 1008 may be in the form of any suitable conductive structures such as solder balls, gold studs, copper pillars, and the like, to connect conductive features of the semiconductor device 100 with the second PCB or other external device. As an alternative to conductive connectors 1008, the substrate pads 1006 may be plated and configured for subsequent connection with the second PCB or other external device by way of solder paste attachment or other suitable conductive attachment processes (e.g., ACF, ACP).

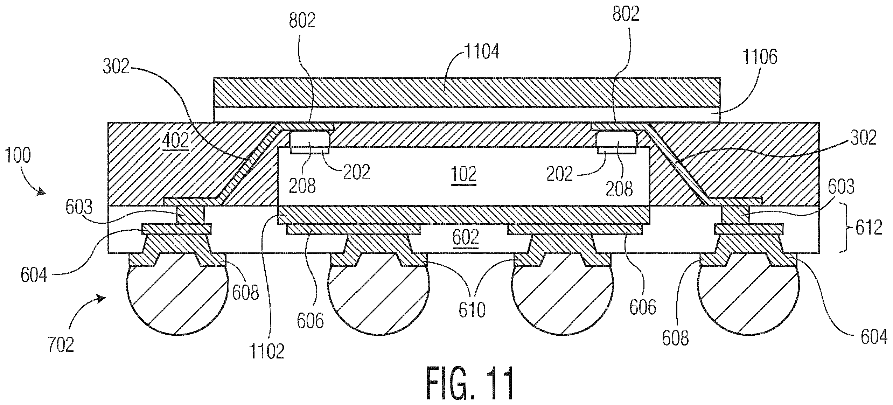

FIG. 11 illustrates, in a simplified cross-sectional view, the example semiconductor device 100 at an alternative stage of manufacture in accordance with an embodiment. At this stage, an external heat sink 1104 is applied to the second major side of the encapsulated semiconductor device 100 and thermally interconnected to the exposed proximal end portions 802 of leads 302. After the proximal end portions 802 of leads 302 are exposed at second first major side as shown in FIG. 8, the heat sink 1104 may be applied by way of a thermal interface material (e.g., thermally conductive paste, thermally conductive adhesive) 1106. In this embodiment, the heat sink 1104 is configured to dissipate heat generated by the semiconductor die 102.

In this embodiment, the package substrate 612 further includes a heat spreader structure 1102 formed from a patterned conductive (e.g., metal) layer of the package substrate. The heat spreader structure 1102 may be formed as a metal plate portion of the patterned conductive layer and configured to serve as a heat spreader. The heat spreader structure 1102 is in thermal contact with the backside of the semiconductor die 102. For example, the heat spreader structure 1102 of the package substrate 612 may be formed directly on the backside of the semiconductor die 102 when the build-up substrate is applied on the first major side of the encapsulated semiconductor device 100. The heat spreader structure 1102 may be incorporated in the package substrate when provided as a pre-formed substrate otherwise applied on the first major side.

The heat spreader structure 1102 is in thermal contact with traces 606 of the package substrate 612 in addition to the backside of the semiconductor die 102. The heat spreader structure 1102, traces 606, pads 610, and respective conductive connectors 702 are configured to form a thermal conduction path to dissipate heat from the semiconductor die 102. Accordingly, the heat spreader structure 1102, traces 606, pads 610, and respective conductive connectors 702 may be characterized as thermally conductive.

Generally, there is provided, a method including placing a semiconductor die on a carrier substrate, the semiconductor die having a plurality of bond pads located at an active side of the semiconductor die; placing a leadframe over the semiconductor die and on the carrier substrate, the leadframe including a plurality of leads, a first lead of the plurality of leads having a proximal end affixed to a first bond pad of the plurality of bond pads and a distal end placed on the carrier substrate; encapsulating with an encapsulant at least a portion of the semiconductor die and the leadframe; separating the carrier substrate from a first major side of the encapsulated semiconductor die and leadframe exposing a distal end portion of the first lead; and applying a package substrate on the first major side, the package substrate including a plurality of conductive traces separated by a non-conductive material. The method may further include interconnecting a first conductive trace of the plurality of conductive traces with the exposed distal end portion of the first lead. The placing the leadframe may further include affixing the proximal end of the first lead to the first bond pad by way of thermocompression bonding or thermosonic bonding. The method may further include affixing a plurality of conductive connectors at a bottom side of the package substrate, the plurality of conductive connectors configured and arranged to provide conductive connections between the package substrate and a printed circuit board. The method may further include back grinding a second major side of the encapsulated semiconductor die and leadframe exposing a proximal end portion of the first lead. The method may further include connecting one of a heat sink, a second packaged semiconductor device, and conductive features of a second package substrate to the exposed proximal end portion of the first lead. The applying the package substrate on the first major side may include forming the package substrate as a build-up structure on the first major side. The separating the carrier substrate from the first major side of the encapsulated semiconductor die and leadframe may further include exposing a backside portion of the semiconductor die. The package substrate may further include a metal plate portion affixed on the exposed backside portion of the semiconductor die, the metal plate portion configured to serve as a heat spreader.

In another embodiment, there is provided, a semiconductor device including a semiconductor die having a plurality of bond pads located at an active side of the semiconductor die; a leadframe including a plurality of leads, a first lead of the plurality of leads having a proximal end affixed to a first bond pad of the plurality of bond pads, and a distal end; an encapsulant encapsulating at least a portion of the semiconductor die and the leadframe, a distal end portion of the first lead exposed at a first major side of the encapsulated semiconductor die and leadframe; and a package substrate applied on the first major side, the package substrate including a plurality of conductive traces separated by a non-conductive material. A first conductive trace of the plurality of conductive traces may be interconnected with the exposed distal end portion of the first lead. A backside of the semiconductor die may be at least partially exposed through the encapsulant at the first major side. The package substrate may further include a heat spreader structure formed on the at least partially exposed backside of the semiconductor die. A proximal end portion of the first lead may be exposed at a second major side of the encapsulated semiconductor die and leadframe. The exposed proximal end portion of the first lead may be configured for connection of one of a heat sink, a second packaged semiconductor device, and conductive features of a second package substrate.

In yet another embodiment, there is provided, a semiconductor device including a semiconductor die having a plurality of bond pads located at an active side of the semiconductor die; a leadframe including a plurality of leads, a first lead of the plurality of leads having a proximal end affixed to a first bond pad of the plurality of bond pads, and a distal end; an encapsulant encapsulating at least a portion of the semiconductor die and the leadframe, a distal end portion of the first lead exposed at a first major side of the encapsulated semiconductor die and leadframe; and a package substrate applied on the first major side, the package substrate including a conductive trace interconnected with the exposed distal end portion of the first lead. The proximal end of the first lead may be affixed to the first bond pad of the semiconductor die by way of thermocompression bonding or thermosonic bonding. The package substrate may be characterized as a build-up structure on the first major side. The semiconductor device may further include a plurality of conductive connectors affixed at a bottom side of the package substrate, the plurality of conductive connectors configured and arranged to provide conductive connections between the package substrate and a printed circuit board. The proximal end of the first lead may be exposed at a second major side of the encapsulated semiconductor die and leadframe.

By now, it should be appreciated that there has been provided a semiconductor device having lead-on-chip interconnects. The semiconductor device includes a semiconductor die and a leadframe at least partially encapsulated with an encapsulant. A first end of leads of the leadframe are affixed to bond pads of the semiconductor die and a second end of the leads are exposed through a bottom side of the encapsulant. A package substrate is formed on the bottom side to interconnect the semiconductor die with a printed circuit board, for example. The package substrate may be formed as a build-up substrate or may be provided as a pre-formed substrate. By forming the semiconductor device with the lead-on-chip interconnects in this manner, the semiconductor device can operate with higher currents than typical bond wires allow. In an alternative configuration, the first end of the leads may be exposed in a subsequent operation thus allowing greater flexibility with through package interconnection by way of the leadframe leads.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method of comprising:
placing a semiconductor die on a carrier substrate, the semiconductor die having a plurality of bond pads located at an active side of the semiconductor die;
placing a leadframe over the semiconductor die and on the carrier substrate, the leadframe including a plurality of leads, a first lead of the plurality of leads having a proximal end affixed to a first bond pad of the plurality of bond pads and a distal end placed on the carrier substrate;
encapsulating with an encapsulant at least a portion of the semiconductor die and the leadframe;
separating the carrier substrate from a first major side of the encapsulated semiconductor die and leadframe exposing a distal end portion of the first lead;
and
applying a package substrate on the first major side, the package substrate including a plurality of conductive traces separated by a non-conductive material.

2. The method of claim 1, further comprising interconnecting a first conductive trace of the plurality of conductive traces with the exposed distal end portion of the first lead.

3. The method of claim 1 or 2, wherein placing the leadframe further includes affixing the proximal end of the first lead to the first bond pad by way of a one of thermocompression bonding and thermosonic bonding.

4. The method of any preceding claim, further comprising affixing a plurality of conductive connectors at a bottom side of the package substrate, the plurality of conductive connectors configured and arranged to provide conductive connections between the package substrate and a printed circuit board.

5. The method of any preceding claim, further comprising back grinding a second major side of the encapsulated semiconductor die and leadframe exposing a proximal end portion of the first lead.

6. The method of claim 5, further comprising connecting one of a heat sink, a second packaged semiconductor device, and conductive features of a second package substrate to the exposed proximal end portion of the first lead.

7. The method of claim 6, wherein applying the package substrate on the first major side includes forming the package substrate as a build-up structure on the first major side.

8. The method of any preceding claim, wherein separating the carrier substrate from the first major side of the encapsulated semiconductor die and leadframe further includes exposing a backside portion of the semiconductor die.

9. The method of claim 8, wherein the package substrate further includes a metal plate portion affixed on the exposed backside portion of the semiconductor die, the metal plate portion configured to serve as a heat spreader.

10. A semiconductor device comprising:
a semiconductor die having a plurality of bond pads located at an active side of the semiconductor die;
a leadframe including a plurality of leads, a first lead of the plurality of leads having a proximal end affixed to a first bond pad of the plurality of bond pads, and a distal end;
an encapsulant encapsulating at least a portion of the semiconductor die and the leadframe, a distal end portion of the first lead exposed at a first major side of the encapsulated semiconductor die and leadframe; and
a package substrate applied on the first major side, the package substrate including a plurality of conductive traces separated by a non-conductive material.

11. The semiconductor device of claim 10, wherein a first conductive trace of the plurality of conductive traces is interconnected with the exposed distal end portion of the first lead.

12. The semiconductor device of claim 10 or 11, wherein a backside of the semiconductor die is at least partially exposed through the encapsulant at the first major side.

13. The semiconductor device of claim 12, wherein the package substrate further includes a heat spreader structure formed on the at least partially exposed backside of the semiconductor die.

14. The semiconductor device of any of claims 10 to 13, wherein a proximal end portion of the first lead is exposed at a second major side of the encapsulated semiconductor die and leadframe.

15. The semiconductor device of claim 14, wherein the exposed proximal end portion of the first lead is configured for connection of one of a heat sink, a second packaged semiconductor device, and conductive features of a second package substrate.
